# EUROPEAN PATENT APPLICATION

(11) **EP 4 719 033 A2**
(43) Date of publication of application: **01.04.2026**
(21) Application number: 25203451.7
(22) Date of filing: 19.09.2025
(51) Int. Cl.: H10W 40/73, H10W 70/63, H10W 70/685

(54) **INTEGRATED CIRCUIT INTERPOSER INCLUDING HEAT EXCHANGE FLUID CHAMBER AND RELATED METHODS**

(30) Priority: 27.09.2024 US 202418900215
(71) Applicant: Eagle Technology, LLC, Melbourne, FL 32919 (US)
(72) Inventor: BAUER, Matthew J., Melbourne, 32901 (US); RENDEK JR., Louis J., Melbourne, 32940 (US); THOMPSON, Jason, Melbourne, 32904 (US)
(74) Representative: Schmidt, Steffen J.

(57) **Abstract**

An interposer **20** for an integrated circuit (IC) device may include an interposer bottom **21** and an interposer top **22** coupled thereto and defining a heat exchange fluid chamber **23** therebetween. The interposer **20** may also include interposer dielectric pillars **24a, 24b** extending within the heat exchange fluid chamber **23** between the interposer bottom **21** and the interposer top **22,** and a heat exchange fluid **25** within the heat exchange fluid chamber. The interposer **20** may also include a wick structure **26** within the heat exchange fluid chamber **23** for moving the heat exchange fluid **25** in a liquid phase into the heat exchange fluid chamber, and electrically conductive through-vias **27** extending within respective ones of the interposer dielectric pillars **24a, 24b** and being exposed on outer surfaces of the interposer bottom **21** and the interposer top **22.**

## Description

### Technical Field

The present invention relates to the field of integrated circuits, and, more particularly, to integrated circuits having a heat exchange fluid chamber interposer, and related methods.

### Background

A three-dimensional integrated circuit (3DIC) is an integrated circuit (IC) manufactured by stacking individual ICs vertically and interconnecting the ICs. The vertically stacked ICs may be interconnected by using, for example, through-silicon vias or copper-copper connections, for example, so that the vertically stacked interconnected ICs function as a single IC. A 3DIC may provide improved operational performance with respect to reduced power and a smaller footprint, for example, relative to a two-dimensional IC. However, a 3DIC may have relatively limited space and compatibility with relatively high input/output count to enable die to die electrical interconnects.

It may be desirable to reduce, remove, or move heat from an 3DIC. One approach for removing heat from a 3DIC includes optimization of through-substrate copper via arrays and reliance on interconnect substrate material, for example, silicon carbide and aluminum nitride. Another approach may include interlayer thermal management. For example, pyrolytic graphite sheets may be bonded to die in a stacked die configuration. While this approach showed improvement of thermal management, production challenges may make this approach less desirable. Moreover, this may not be viable for large-scale production efforts. Another approach to thermal management in a 3DIC may include the use of micro-channel pumped fluid. However, this technique is relatively complex based upon additional components, such as, for example, a pump, to enable forced liquid cooling.

A constant conductance heat pipe (CCHP), commonly referred to as a heat pipe is a passive device that includes a hermetic enclosure (typically metal to enable conductive coupling to dissipating structures/components), and a wick structure within a vapor space to provide capillary return of working fluid from the condenser section back to the evaporator. A working fluid that changes phase (e.g., liquid to vapor boiling) shuttles heat within the vapor space between an evaporator section (e.g., where heat is introduced) and a condenser section (e.g., where heat is rejected and the working fluid reverts back to a liquid).

### Summary

An interposer for an integrated circuit (IC) device, the interposer may include an interposer bottom and an interposer top coupled thereto and defining a heat exchange fluid chamber therebetween, and a plurality of interposer dielectric pillars extending within the heat exchange fluid chamber between the interposer bottom and the interposer top. The interposer may also include a heat exchange fluid within the heat exchange fluid chamber, and a wick structure within the heat exchange fluid chamber for moving the heat exchange fluid in a liquid phase into the heat exchange fluid chamber. The interposer may also include a plurality of electrically conductive through-vias extending within respective ones of the plurality of interposer dielectric pillars and being exposed on outer surfaces of the interposer bottom and the interposer top.

The heat exchange fluid chamber, heat exchange fluid, and wick structure may define a passive thermal removal arrangement, for example. The interposer may include a coupling interface region between the interposer bottom and interposer top.

The interposer may include a plurality of blind thermally conductive vias extending into at least one of the interposer bottom and interposer top. The interposer may include a thermally conductive layer lining the heat exchange fluid chamber.

The thermally conductive layer may include metal, for example. The thermally conductive layer may include a nanodiamond layer, for example.

Each of the electrically conductive through vias may include copper. Each of the interposer bottom and interposer top may include one of glass and quartz.

A method aspect is directed to a method of making an interposer. The method may include coupling an interposer bottom to an interposer top to define a heat exchange fluid chamber therebetween and forming a plurality of interposer dielectric pillars extending within the heat exchange fluid chamber between the interposer bottom and the interposer top. The method may also include forming a heat exchange fluid within the heat exchange fluid chamber and forming a wick structure within the heat exchange fluid chamber for moving the heat exchange fluid in a liquid phase into the heat exchange fluid chamber. The method may further include forming a plurality of electrically conductive through-vias extending within respective ones of the plurality of interposer dielectric pillars and being exposed on outer surfaces of the interposer bottom and the interposer top.

### Brief Description of the Drawings

FIG. 1 is a schematic cross-sectional diagram of an interposer for an integrated circuit (IC) in accordance with an embodiment.
FIGS. 2A-2E are schematic cross-sectional diagrams of steps in a fabrication process of making the interposer of FIG. 1.
FIG. 3 is a schematic cross-sectional diagram of a portion of the fabrication process of an interposer for an IC in accordance with another embodiment.
FIG. 4 is a schematic diagram of an IC assembly including respective interposers in accordance with an embodiment.
FIG. 5 is a schematic diagram of a portion of the IC assembly of FIG. 4 illustrating electrical interconnection between adjacent stacked die and the respective interposer.

### Detailed Description

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout, and prime notation is used to indicate similar elements in alternative embodiments.

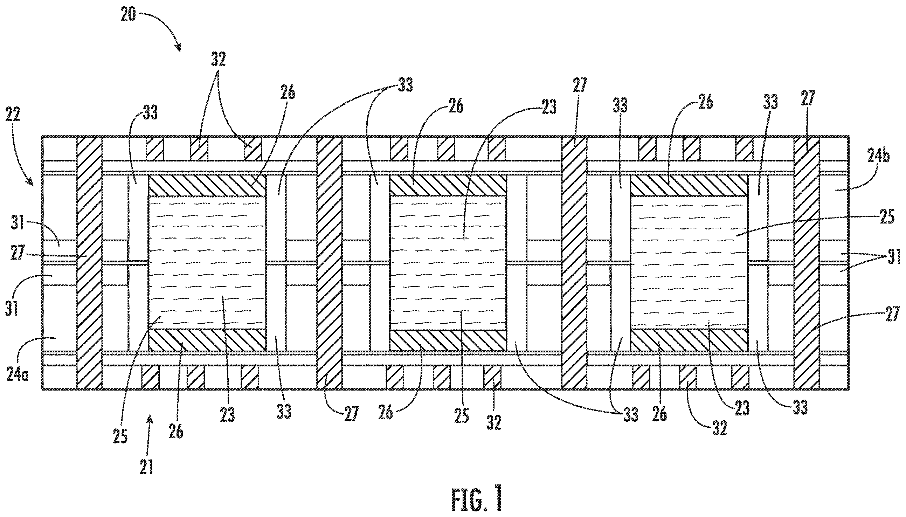

Referring initially to FIG. 1, an interposer 20 for an integrated circuit (IC) device includes an interposer bottom 21 and an interposer top **22** coupled to the interposer bottom. The interposer bottom **21** may include one of glass and quartz, for example. The interposer top **22** may also include one of glass and quartz, for example. The glass and/or quartz may have a coefficient of thermal expansion (CTE) set to, or match, the CTE of other components, as will be described in further detail below. The top and/or bottom interposers **21, 22** may be or include other or additional materials.

The interposer bottom **21** and the interposer top **22** together define a heat exchange fluid chamber **23** therebetween. A thermally conductive layer **33** lines the heat exchange fluid chamber **23.** The thermally conductive layer **33** may include any one or more of metal and a nanodiamond layer. Of course, the thermally conductive layer **33** may include other or additional materials.

A coupling interface region **31** is between the interposer bottom **21** and the interposer top **22.** The coupling interface region **31** may include silicone oxide (SiO₂), for example. Further details regarding the interface region **31** are described below.

Interposer dielectric pillars **24a, 24b** extend within the heat exchange fluid chamber **23** between the interposer bottom **21** and the interposer top **22.** A wick structure **26** within the heat exchange fluid chamber **23** is for moving the heat exchange fluid **25** in a liquid phase into the heat exchange fluid chamber.

A heat exchange fluid **25** is within the heat exchange fluid chamber **23.** As will be appreciated by those skilled in the art, the heat exchange fluid chamber **23,** the heat exchange fluid **25,** and the wick structure **26** together define a passive thermal removal arrangement, for example, to remove heat. The heat exchange fluid chamber **23,** the heat exchange fluid **25,** and the wick structure **26** together define a heat pipe arrangement that has increased mechanical and thermal performance (e.g., coefficient of thermal expansion (CTE)).

Electrically conductive through-vias **27** extend within respective ones of the interposer dielectric pillars **24a, 24b.** The electrically conductive through-vias **27** are exposed on outer surfaces of the interposer bottom **21** and the interposer top **22.** The electrically conductive through-vias **27** may be copper and/or aluminum, for example. The electrically conductive through-vias **27** may be another material or include other materials, for example, with increased thermal performance, as will be appreciated by those skilled in the art.

Blind thermally conductive vias **32** extend into the interposer top **22** and the interposer bottom **21.** While the blind thermally conductive vias **32** extend into the interposer top **22** and interposer bottom **21,** those skilled in the art will appreciate that the blind thermally conductive vias may extend into either the interposer top or interposer bottom. In some embodiments, the interposer **20** may not include blind thermally conductive vias **32.**

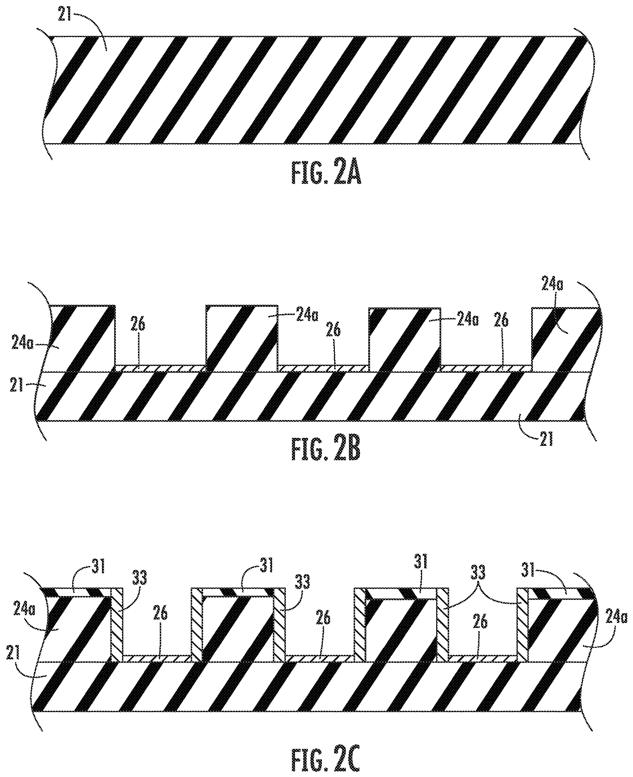

Referring now to FIGS. 2A-2E, further details of the interposer **20** will be described with reference to an exemplary fabrication process. The interposer bottom **21,** for example, in the form of a quartz wafer (FIG. 2A), is laser irradiated to create bottom interposer dielectric pillars **24a,** for example, defining part of an internal wick topology. A femtosecond laser may be used to provide the laser irradiation. The interposer bottom **21** is chemically etched to remove weakened material created by the laser irradiation process. This combination of the femtosecond laser irradiation and chemical etching defines a FLICE process. FLICE is a process whereby first a transparent material is irradiated with a femtosecond laser at its focal point, breaking bonds and weakening certain areas, for example, to permit three-dimensional (3D) topologies to be formed.

"FLICE stops", or light blocking materials, can be used to more finely control end points during the laser irradiation process. The weakened areas created by the laser irradiation are chemically and selectively etched relative to the non-weakened areas to create the desired 3D topology.

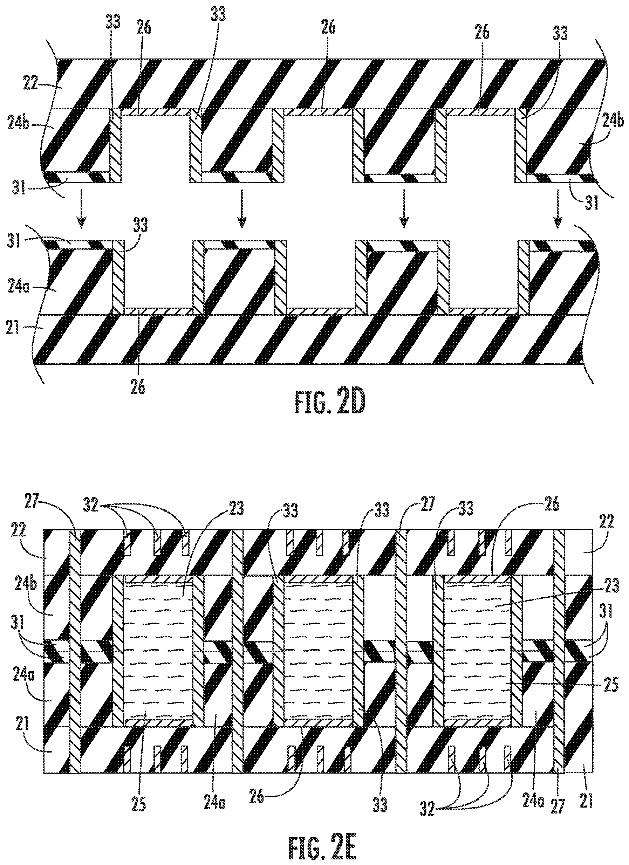

The resultant interposer bottom **21** includes interposer dielectric pillars **24a** (e.g., glass) and an etched wick structure **26** (FIG. 2B). The above described FLICE operations are performed on the interposer top **22** so that the interposer top is a duplicate of the interposer bottom **21** including top interposer dielectric pillars **24b** (FIG. 2D). The thermally conductive layer **33** is applied to the interposer bottom **21** and the interposer top **22** to create, for example, a metallized wick structure **26** (FIGS. 2C and 2D) (e.g., formed based upon FLICE operations). The thermally conductive layer **33** may be applied by way of a physical vapor deposition (PVD), for example. In embodiments where the thermally conductive layer **33** is in the form of a nanodiamond layer, the thermally conductive layer may be deposited via electrophoretic deposition, for example. As will be appreciated by those skilled in the art, the thermally conductive layer **33** is compatible with the target substrate and may provide improved lateral conduction within the heat exchange fluid chamber **23** and thru-plane conductive coupling from the heat source to the heat exchange fluid **25.**

Bonding operations are performed (FIG. 2D). For example, the surfaces of the bottom and top interposers **21, 22** are planarized (e.g., ~<0.5 nm surface root mean square (RMS) roughness), subject to an oxide deposition, for example SiO₂, and then planarized again (e.g., using a chemical mechanical polish (CMP) process). Plasma activation is performed and the interposer bottom **21** and interposer top **22** are bonded together or mated, for example, joining deposited SiO₂ (FIGS. 2D and 2E). The plasma activation may be followed by deionized (DI) wafer rinse an N₂ drying processes. The plasma activation process may define the coupling interface region **31.** Bond strength may be improved by annealing with a temperature greater than 200°C, for example. The heat exchange fluid chamber **23** is defined upon the mating. The head exchange fluid chamber **23** may be define a hermetic vapor space, for example, for the heat exchange fluid **25.**

Once the interposer bottom **21** and interposer top **22** are bonded, the electrically conductive through-vias **27** and blind thermally conductive vias **32** are formed, first by forming the openings that define these vias. As will be appreciated by those skilled in the art, the blind thermally conductive vias **32** may provide increased through-plane conduction to the vapor space or heat exchange fluid chamber **23,** while the electrically conductive through-vias **27** provide electrical input/output.

The openings are plated, for example, with a copper deposition. The openings may be plated with other and/or additional metals or materials (FIG. 2E). The vapor space or heat exchange fluid chamber **23** is filled with the heat exchange fluid **25** (FIG. 2E). During operations, the wick structure **26** within the vapor space or heat exchange fluid chamber **23** provides capillary return of the heat exchange fluid **25** from a condenser or heat sink section back to an evaporator or heat generator.

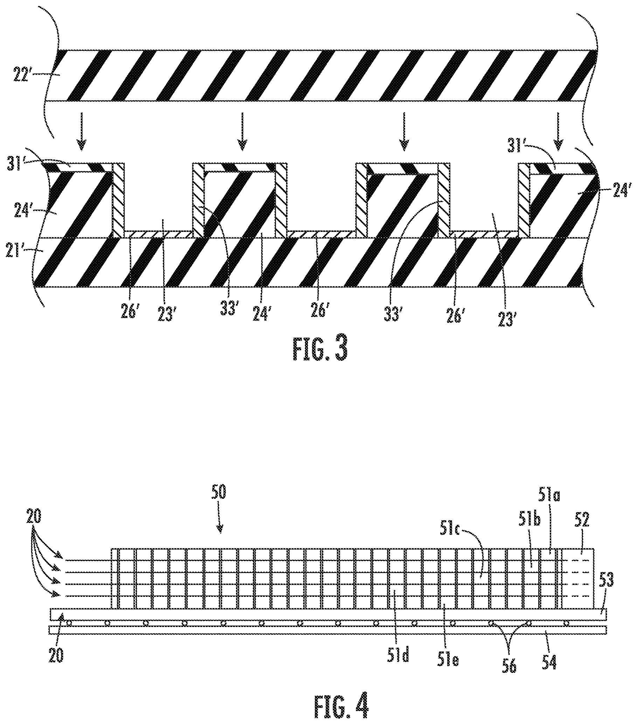

Referring now briefly to FIG. 3, in another embodiment, the interposer bottom **21'** may be lasered and etched while the interposer top **22'** may not be lasered and etched. The etched interposer bottom **21'** may thus be bonded to the non-etched interposer to define the heat exchange fluid chamber **23'.** In other words, the interposer dielectric pillars **24'** extend within the heat exchange fluid chamber **23'** based upon etching of the interposer bottom **21'.** The wick structure **26',** electrically conductive through-vias, blind thermally conductive vias, thermally conductive layer **33',** and the coupling interface region **31'** are similar to the embodiment described above. Of course, in some embodiments, the interposer bottom **21'** and interposer top **22'** may be reversed such that the interposer top may be lasered and etched while the interposer bottom **21'** may not be lasered and etched.

Decreasing size, weight, and power (SWaP) in electronics typically results in the packing of a higher density of heat producing electronics in a smaller space. For 3DICs in particular, this problem may typically be compounded by stacking of die in the vertical dimension, creating additional thermal resistances for interior die to transport heat to the package. Removal of this heat relatively quickly becomes a factor in the ability to successfully miniaturize electronics. The interposer 20 provides an approach to increased heat removal. As will be understood by those skilled in the art, the interposer **20** may provide thermally optimized wick structures by tailoring enclosure material conductivity (metal or nano-particle deposition). The interposer **20** may also provide the capability of enhancing conductive coupling between the heat generating source and the heat exchange fluid based upon, for example, a hermetic, constant conductance heat pipe (CCHP). Thus, the interposer **20** may provide between 5 and 50 times greater effective conductivity versus other approaches, for example, diamond as a heat transfer material.

A method aspect is directed to a method of making an interposer **20.** The method includes coupling an interposer bottom **21** to an interposer top **22** to define a heat exchange fluid chamber **23** therebetween and forming a plurality of interposer dielectric pillars **24a, 24b** extending within the heat exchange fluid chamber between the interposer bottom and the interposer top. The method also includes forming a heat exchange fluid **25** within the heat exchange fluid chamber **23** and forming a wick structure **26** within the heat exchange fluid chamber for moving the heat exchange fluid in a liquid phase into the heat exchange fluid chamber. The method further includes forming a plurality of electrically conductive through-vias **27** extending within respective ones of the plurality of interposer dielectric pillars **24a, 24b** and being exposed on outer surfaces of the interposer bottom **21** and the interposer top **22.**

Referring now to FIG. 4, the interposer **20** may be particularly advantageous for use within IC assembly **50,** for example, a 3DIC. More particularly, an exemplary IC assembly **50** includes stacked IC die **51a-51e.** While five stacked IC die **51a-51e** are illustrated, those skilled in the art will appreciate that there may be any number of stacked IC die.

A respective interposer **20** is between, for example, bonded between, adjacent ones of the stacked die **51a-51e.** While five stacked die **51a-51e** are illustrated there may be any number of stacked die. Each interposer **20** is similar to those described in the embodiments above.

Each interposer **20** is compatible with wafer-to-wafer or die-to-wafer processing within existing 3DIC fabrication infrastructure. For example, SiO₂ may be deposited onto a bonding surface of each interposer **20.** The bond surface of the interposer **20** may be thermally enhanced by the blind thermally conductive vias. Chemical mechanical polishing (CMP) may be performed to each wafer or stacked die **51a-51e.** Top and bottom side oxide deposition may be desirable for certain multi-stack 3DIC arrangements. The wafers or stacked die **51a-51e** may be joined using DBI^{®} process technology (direct bond interconnect). As will be appreciated by those skilled in the art, annealing may cause both electrical through-vias and thermal blind vias to expand metallic pillars to form interconnects. Other interconnect processes, such as, for example, thermocompression bonding or solder bonding may be used. Indeed, while both stacked wafers and stacked die **51a-51e** are described, those skilled in the art will appreciate that an integrated wafer may be singulated.

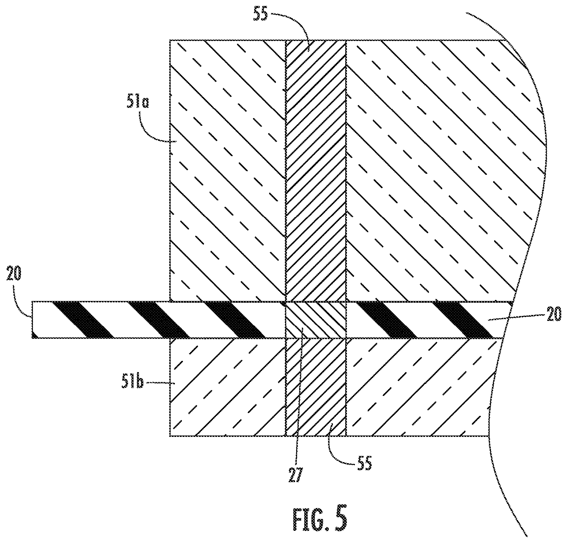

Referring additionally and briefly to FIG. 5, with respect to the electrical interconnects, each stacked die **51a-51e** includes a through-substrate via **55.** The through-substrate vias **55** are aligned with the electrically conductive through-vias **27** (i.e., through-glass vias) to form electrical interconnects therewith. Accordingly, electrical interconnect, e.g., high-density interconnect (HDI) is enabled by the electrically conductive through-vias **27** bridging die-to-die (through-substrate) connections or vias **55.** In an embodiment, the through-substrate vias **55** may be offset from the electrically conductive through-vias **27** by way of redistribution layer (RDL) routing therebetween.

Referring again to FIG. 4, an electrical substrate **53** carries the stacked die **51a-51e** and respective interposers **20.** A printed circuit board (PCB) **54** is coupled to the electrical substrate **53.** More particularly, the PCB is coupled to a bottom side of the electrical substrate **53** by way of a coupling arrangement, such as, for example, a ball grid array **56.** The stacked die **51a-51e** and respective interposers **20** are carried by a top side of the electrical substrate **53.**

A heat rejection structure **52** is adjacent the stacked die **51a-51e** and the respective interposers **20.** The heat rejection structure **52** is carried by the electrical substrate adjacent the stacked die **51a-51e.** The heat rejection structure **52** may be considered a secondary heat rejection structure, as the interposers **20** may be considered a primary heat rejection or removal structure for the IC assembly **50.**

As will be appreciated by those skilled in the art, the interposers **20** are mechanically, thermally and electrically joined to adjacent die wafers **51a-51e** (or singulated dice) to form a fully functional 3-dimensional integrated circuit (3DIC) or IC assembly **50.** The IC assembly **50** provides integral passive thermal management for the acquisition or transport of waste heat to the periphery of the die stack, for example to the heat rejection structure **52.**

Indeed, the IC assembly **50** may permit integration of a form of passive, constant conductance heat pipe (CCHP) technology into stacked die architectures. The IC assembly **50** may provide between 5 and 50 times greater effective conductivity versus diamond, for example, and may be compatible with relatively low loss substrate material, e.g., coefficient of thermal expansion (CTE) matched material (quartz/glass). As will be appreciated by those skilled in the art, the CTE of glass, for example, may be tuned through different additives, while quartz, for example, naturally has a relatively low CTE. The IC assembly **50** may also provide the capability of using 1 or N interposers **20** between adjacent die **51a-51e** depending on the desired use case.

Moreover, the IC assembly **50** may be considered to be compatible with industry standard wafer-processing technology, can be offered as a commercial off-the-shelf (COTS) solution with what is considered a standard pitch or in custom configurations. The IC assembly **50** also, as described above, enables HDI between adjacent ones of the stacked die **51a-51e** and does so without additional three-dimensional subtractive structures in inorganic (i.e., wafer) materials, as the wick structure formation using deep reactive ion etching (DRIE) is constrained to two dimensions.

A method aspect is directed to a method of making an IC assembly **50.** The method includes coupling a respective interposer **20** between adjacent ones of a plurality of stacked IC die **51a-51e.** Each interposer **20** may include an interposer bottom **21** and an interposer top **22** coupled thereto and defining a heat exchange fluid chamber **23** therebetween and a plurality of interposer dielectric pillars **24a, 24b** extending within the heat exchange fluid chamber between the interposer bottom and the interposer top. Each interposer includes a heat exchange fluid **25** within the heat exchange fluid chamber **23** and a wick structure **26** within the heat exchange fluid chamber for moving the heat exchange fluid in a liquid phase into the heat exchange fluid chamber. Each interposer includes a plurality of electrically conductive through-vias **27** extending within respective ones of the plurality of interposer **24a, 24b** and being exposed on outer surfaces of the interposer bottom **21** and the interposer top **22.**

While several embodiments have been described herein, it should be appreciated by those skilled in the art that any element or elements from one or more embodiments may be used with any other element or elements from any other embodiment or embodiments. Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. An interposer for an integrated circuit (IC) device, the interposer comprising:
an interposer bottom and an interposer top coupled thereto and defining a heat exchange fluid chamber therebetween;
a plurality of interposer dielectric pillars extending within the heat exchange fluid chamber between the interposer bottom and the interposer top;
a heat exchange fluid within the heat exchange fluid chamber;
a wick structure within the heat exchange fluid chamber for moving the heat exchange fluid in a liquid phase into the heat exchange fluid chamber; and
a plurality of electrically conductive through-vias extending within respective ones of the plurality of interposer dielectric pillars and being exposed on outer surfaces of the interposer bottom and the interposer top.

2. The interposer of Claim 1 wherein the heat exchange fluid chamber, heat exchange fluid, and wick structure define a passive thermal removal arrangement.

3. The interposer of Claim 1 comprising a coupling interface region between the interposer bottom and interposer top.

4. The interposer of Claim 1 comprising a plurality of blind thermally conductive vias extending into at least one of the interposer bottom and interposer top.

5. The interposer of Claim 1 comprising a thermally conductive layer lining the heat exchange fluid chamber.

6. A method of making an interposer comprising:
coupling an interposer bottom to an interposer top to define a heat exchange fluid chamber therebetween;
forming a plurality of interposer dielectric pillars extending within the heat exchange fluid chamber between the interposer bottom and the interposer top;
forming a heat exchange fluid within the heat exchange fluid chamber;
forming a wick structure within the heat exchange fluid chamber for moving the heat exchange fluid in a liquid phase into the heat exchange fluid chamber; and
forming a plurality of electrically conductive through-vias extending within respective ones of the plurality of interposer dielectric pillars and being exposed on outer surfaces of the interposer bottom and the interposer top.

7. The method of Claim 6 wherein forming the wick structure comprises forming the wick structure using a femtosecond laser irradiation and chemical etching (FLICE) process.

8. The method of Claim 6 wherein the heat exchange fluid chamber, heat exchange fluid, and wick structure define a passive thermal removal arrangement.

9. The method of Claim 6 comprising forming a coupling interface region between the interposer bottom and interposer top.

10. The method of Claim 6 comprising forming a plurality of blind thermally conductive vias extending into at least one of the interposer bottom and interposer top.
